(19) Europäisches Patentamt
European Patent Office
Office européen des brevets

(11) EP 2 660 617 A1

(12) EUROPEAN PATENT APPLICATION
published in accordance with Art. 153(4) EPC

(43) Date of publication:
06.11.2013 Bulletin 2013/45

(51) Int Cl.:
G01R 33/09 (2006.01)   G01R 15/20 (2006.01)

(21) Application number: 11852773.8

(22) Date of filing: 25.11.2011

(86) International application number:
PCT/JP2011/077245

(87) International publication number:
WO 2012/090631 (05.07.2012 Gazette 2012/27)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR

(30) Priority: 27.12.2010 JP 2010289629

(71) Applicant: Alps Green Devices Co., Ltd.
Ota-ku, Tokyo 145-8501 (JP)

(72) Inventors:
• IDE, Yosuke
  Tokyo 145-8501 (JP)
• SAITO, Masamichi
  Tokyo 145-8501 (JP)
• TAKAHASHI, Akira
  Tokyo 145-8501 (JP)
• ICHINOHE, Kenji
  Tokyo 145-8501 (JP)

(74) Representative: Klunker . Schmitt-Nilson . Hirsch
Patentanwälte
Destouchesstrasse 68
80796 München (DE)

(54) **ELECTROMAGNETIC PROPORTIONAL CURRENT SENSOR**

(57) Deviations in a zero-field resistance value ($R_0$) and a Temperature Coefficient Resistivity ($TCR_0$) among elements are eliminated, and current measurement is performed with high accuracy. A magnetic proportional current sensor includes a magnetic-field detection bridge circuit (13) constituted by four magnetoresistive elements (122a to 122c, 123) having resistance values changed with application of an induced magnetic field from a current to be measured. Each of the four magnetoresistive elements (122a to 122c, 123) includes a ferromagnetic pinned layer made up of a first ferromagnetic film and a second ferromagnetic film antiferromagnetically coupled to each other with an antiparallel coupling film interposed therebetween, a nonmagnetic intermediate layer, and a soft magnetic free layer. The first ferromagnetic film and the second ferromagnetic film have substantially equal Curie temperatures and have magnetization magnitudes with a substantially zero difference therebetween. The ferromagnetic pinned layers in the three magnetoresistive elements (122a to 122c) have a same magnetization direction, and the ferromagnetic pinned layer in the one magnetoresistive element (123) has a magnetization direction differing by 180° from that of the ferromagnetic pinned layers in the three magnetoresistive elements (122a to 122c).

FIG. 1

**Description**

Technical Field

The present invention relates to a magnetic proportional current sensor using a magnetoresistive element (e.g., a TMR element or a GMR element).

Background Art

In an electric car, a motor is driven using electricity generated by an engine, and the magnitude of a current for driving the motor is detected by, e.g., a current sensor. The current sensor is constituted such that a magnetic core having a cutout (core gap) in its part is disposed around a conductor, and a magnetism detection element is disposed in the core gap.

As the magnetism detection element for the current sensor, there is used, for example, a magnetoresistive element (e.g., a TMR element or a GMR element) having a multilayered structure including a pinned magnetic layer of which magnetization direction is pinned, a nonmagnetic layer, and a free magnetic layer of which magnetization direction varies with respect to an external magnetic field. In the current sensor using such a magnetoresistive element, a full-bridge circuit is constituted by the magnetoresistive element and a fixed resistance element (Patent Literature (PTL) 1).

Citation List

Patent Literature

PTL 1: Japanese Unexamined Patent Application Publication No. 2007-248054

Summary of Invention

Technical Problem

However, when the full-bridge circuit is constituted by the magnetoresistive element and the fixed resistance element, a zero-field resistance value ($R_0$) and a Temperature Coefficient Resistivity ($TCR_0$) at a zero magnetic field differ between the magnetoresistive element and the fixed resistance element because of a difference between a film structure of the magnetoresistive element and a film structure of the fixed resistance element. This results in the problem that a midpoint potential, i.e., an output of the bridge circuit, varies with change of temperature and an error occurs in the output, whereby a current cannot be measured with high accuracy.

The present invention has been made in view of the above-described state of the art, and an object of the present invention is to provide a magnetic proportional current sensor capable of eliminating deviations in the zero-field resistance value ($R_0$) and the TCR (Temperature  Coefficient Resistivity)$_0$ among elements and measuring a current with high accuracy.

Solution to Problem

The present invention provides a magnetic proportional current sensor comprising a magnetic-field detection bridge circuit constituted by four magnetoresistive elements having resistance values changed with application of an induced magnetic field from a current to be measured, the magnetic-field detection bridge circuit having two outputs generating a voltage difference substantially proportional to the induced magnetic field, and a magnetic shield for attenuating the induced magnetic field, the magnetic proportional current sensor calculating a current value of the measured current by employing the voltage difference generated in the magnetic-field detection bridge circuit, wherein each of the four magnetoresistive elements includes a ferromagnetic pinned layer of self-pinned type made up of a first ferromagnetic film and a second ferromagnetic film antiferromagnetically coupled to each other with an antiparallel coupling film interposed therebetween, a nonmagnetic intermediate layer, and a soft magnetic free layer, the first ferromagnetic film and the second ferromagnetic film having substantially equal Curie temperatures and having magnetization magnitudes with a substantially zero difference therebetween, the  ferromagnetic pinned layers in three of the four magnetoresistive elements have a same magnetization direction, and the ferromagnetic pinned layer in the remaining one magnetoresistive element has a magnetization direction differing by 180° from the magnetization direction of the ferromagnetic pinned layers in the three magnetoresistive elements.

With those features, since the magnetism detection bridge circuit is constituted by the four magnetoresistive elements having the same film structure, deviations in the zero-field resistance value ($R_0$) and the Temperature Coefficient

Resistivity ($TCR_0$) among the elements can be eliminated. Therefore, variations of a midpoint potential can be reduced regardless of the environmental temperature, and the current measurement can be performed with high accuracy.

In the magnetic proportional current sensor according to the present invention, preferably, the magnetic shield and the magnetic-field detection bridge circuit are formed on a same substrate.

In the magnetic proportional current sensor according to the present invention, preferably, the magnetic shield is arranged on a side closer to the measured current than the magnetic-field detection bridge circuit.

In the magnetic proportional current sensor according  to the present invention, preferably, each of the four magnetoresistive elements has a zigzag folded shape in which a plurality of band-like elongate patterns are arranged with lengthwise directions of the patterns being parallel to each other, and the induced magnetic field is applied in a direction perpendicular to the lengthwise direction.

In the magnetic proportional current sensor according to the present invention, preferably, the first ferromagnetic film is made of a CoFe alloy containing 40 atom% to 80 atom% of Fe, and the second ferromagnetic film is made of a CoFe alloy containing 0 atom% to 40 atom% of Fe.

In the magnetic proportional current sensor according to the present invention, preferably, the magnetic shield is made of a material having high magnetic permeability, selected from a group consisted of an amorphous magnetic material, a Permalloy-based magnetic material, and an iron-based microcrystal material.

Advantageous Effects of Invention

The magnetic proportional current sensor of the present invention includes a magnetic-field detection bridge circuit constituted by four magnetoresistive elements having resistance values changed with application of an induced magnetic field from a current to be measured. Each of the four magnetoresistive elements includes a ferromagnetic pinned layer made up of a first ferromagnetic film and a  second ferromagnetic film antiferromagnetically coupled to each other with an antiparallel coupling film interposed therebetween, a nonmagnetic intermediate layer, and a soft magnetic free layer, the first ferromagnetic film and the second ferromagnetic film having substantially equal Curie temperatures and having magnetization magnitudes with a substantially zero difference therebetween. The ferromagnetic pinned layers in the three magnetoresistive elements have a same magnetization direction, and the ferromagnetic pinned layer in the remaining one magnetoresistive element has a magnetization direction differing by 180° from the magnetization direction of the ferromagnetic pinned layers in the three magnetoresistive elements. Therefore, output errors caused by differences in the zero-field resistance value ($R_0$) and the Temperature Coefficient Resistivity ($TCR_0$) among the elements can be eliminated, and the current measurement can be performed with high accuracy.

Brief Description of Drawings

[Fig. 1] Fig. 1 illustrates a magnetic proportional current sensor according to an embodiment of the present invention.
[Fig. 2] Fig. 2 illustrates the magnetic proportional current sensor according to the embodiment of the present invention.
[Fig. 3] Fig. 3 is a sectional view of the magnetic proportional current sensor illustrated in Fig. 1.
[Fig. 4] Fig. 4 illustrates a magnetism detection bridge circuit in the magnetic proportional current sensor according to the embodiment of the present invention.
[Fig. 5] Fig. 5 illustrates a current measurement state of the magnetic proportional current sensor illustrated in Fig. 2.
[Fig. 6] Fig. 6 illustrates the magnetism detection bridge circuit in the magnetic proportional current sensor illustrated in Fig. 5.
[Fig. 7] Fig. 7 illustrates a current measurement state of the magnetic proportional current sensor illustrated in Fig. 2.
[Fig. 8] Fig. 8 illustrates the magnetism detection bridge circuit in the magnetic proportional current sensor illustrated in Fig. 7.
[Fig. 9] Fig. 9 is a graph depicting an R-H curve of a magnetoresistive element in the magnetic proportional current sensor according to the embodiment of the present invention.
[Fig. 10] Figs. 10(a) to 10(c) are explanatory views to explain a method for manufacturing the magnetoresistive element in the magnetic proportional current sensor according to the embodiment of the present invention.
[Fig. 11] Figs. 11(a) to 11(c) are explanatory views to explain a method for manufacturing the magnetoresistive element in the magnetic proportional current sensor according to the embodiment of the present invention.

Description of Embodiments

An embodiment of the present invention will be described in detail below with reference to the accompanying drawings.

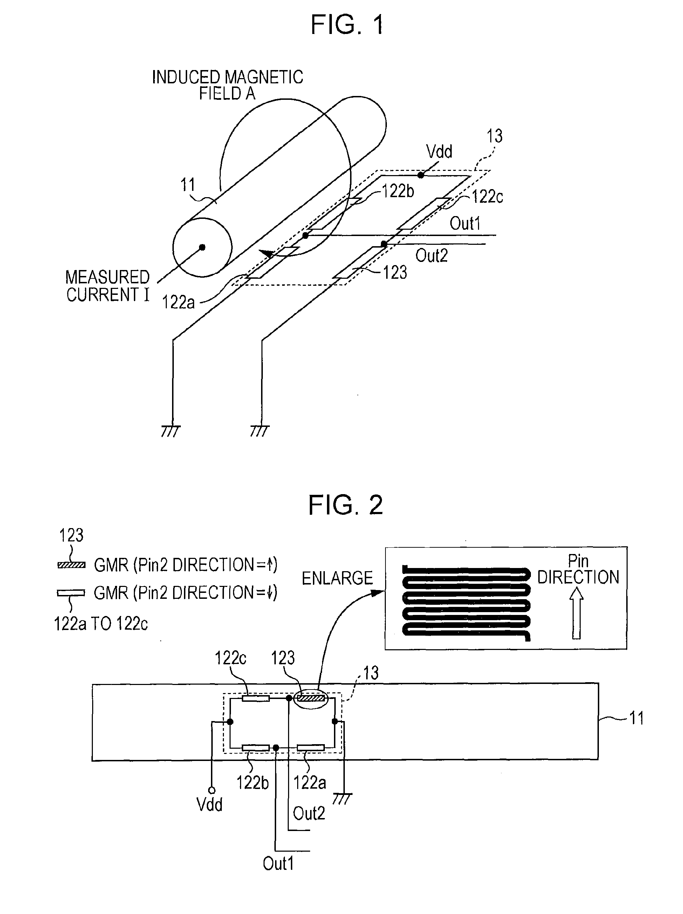

Figs. 1 and 2 illustrate a magnetic proportional current sensor according to an embodiment of the present invention. In the embodiment, the magnetic proportional current sensor illustrated in Figs. 1 and 2 is disposed near a conductor 11 through which a current I to be measured flows. The magnetic proportional current sensor includes a magnetic-field detection bridge circuit (magnetism detection bridge circuit) 13 for detecting an induced magnetic field that is generated by the measured current I flowing through the conductor 11. The magnetic-field detection bridge circuit 13 includes four magnetoresistive elements 122a to 122c and 123 of which resistance values change with application of the induced magnetic field from the measured current A. Thus, a magnetic proportional current sensor with high sensitivity can be realized by employing the magnetic-field detection bridge circuit 13 including the magnetoresistive elements.

The magnetic-field detection bridge circuit 13 has two outputs generating a voltage difference that is substantially proportional to the induced magnetic field generated by the measured current I. In the magnetic-field detection bridge circuit 13 illustrated in Fig. 2, an electric power source Vdd is connected to a connecting point between the magnetoresistive element 122b and the magnetoresistive element 122c, and a ground (GND) is connected to a connecting point between the magnetoresistive element 122a and the magnetoresistive element 123. Furthermore, in the magnetic-field detection bridge circuit 13, one output (Out1) is taken out from a connecting point between the magnetoresistive element 122a and the magnetoresistive element 122b, and the other output (Out2) is taken out from a connecting point between the magnetoresistive element 122c and the magnetoresistive element 123. The magnetic proportional current sensor calculates the measured current I from a voltage difference between those two outputs.

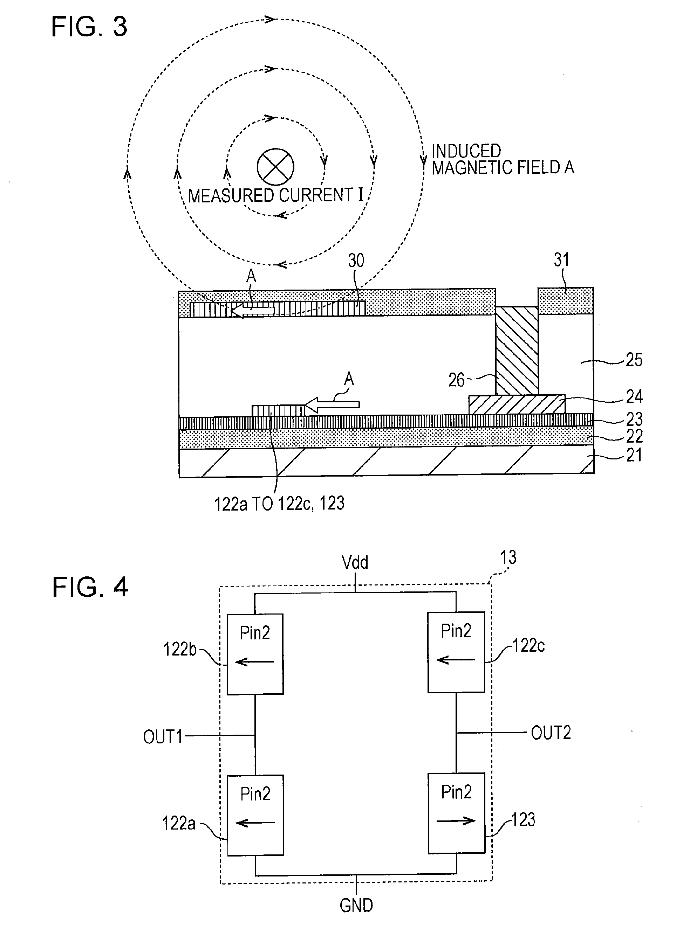

Fig. 3 is a sectional view of the magnetic proportional current sensor illustrated in Fig. 1. In the magnetic proportional current sensor according to the embodiment, as illustrated in Fig. 3, a magnetic shield 30 and the magnetic-field detection bridge circuit 13 are formed on a same substrate 21. In the structure illustrated in Fig. 3, the magnetic shield 30 is arranged closer to the measured current I. Stated in another way, the magnetic shield 30 and the magnetoresistive elements 122a to 122c and 123 are arranged in that order from the side closer to the conductor 11. With such an arrangement, the magnetoresistive elements 122a to 122c and 123 can be positioned farther away from the conductor 11, and the induced magnetic field applied to the magnetoresistive elements 122a to 122c and 123 from the measured current I can be reduced. As a result, the current measurement can be performed over a wider range.

The layer structure illustrated in Fig. 3 will be described in detail. In the magnetic proportional current sensor illustrated in Fig. 3, a thermal silicon oxide film 22 as an insulating layer is formed on the substrate 21. An aluminum oxide film 23 is formed on the thermal silicon oxide film 22. The aluminum oxide film 23 can be formed by sputtering or some other suitable method. Moreover, for example, a silicon substrate is used as the substrate 21.

On the aluminum oxide film 23, the magnetoresistive elements 122a to 122c and 123 are formed and the magnetic-field detection bridge circuit 13 is constituted. For example, a TMR element (tunneling magnetoresistive element) or a GMR element (giant magnetoresistive element) can be used as each of the magnetoresistive elements 122a to 122c and 123. The film structure of the magnetoresistive element used in the magnetic proportional current sensor according to the present invention will be described later.

As partly illustrated in Fig. 2 as an enlarged view, the magnetoresistive element is preferably a GMR element having a zigzag folded shape in which a plurality of band-like elongate patterns (stripes) are arranged with their lengthwise directions being parallel to each other (i.e., a meander shape). In the meander shape, the direction of a sensitivity axis (Pin direction) is a direction (i.e., a widthwise direction of the stripe) perpendicular to the lengthwise direction of the elongate pattern (i.e., the lengthwise direction of the stripe). In the meander shape, the induced magnetic field is applied in the direction (i.e., the widthwise direction of the stripe) perpendicular to the lengthwise direction of the stripe.

A width of the meander shape in the pin (Pin) direction is preferably 1 $\mu$m to 10 $\mu$m, taking linearity into consideration. In that case, taking linearity into consideration, it is desired that the lengthwise direction of the meander shape is perpendicular to the direction of the induced magnetic field. By employing the meander shape described above, an output of the magnetoresistive element can be taken out with a smaller number of terminals (i.e., two terminals) than that required when employing a Hall element.

An electrode 24 is also formed on the aluminum oxide film 23. The electrode 24 can be formed by forming a film of an electrode material, and thereafter executing photolithography and etching.

A polyimide layer 25 is formed as an insulating layer on the aluminum oxide film 23 on which the magnetoresistive elements 122a to 122c and 123 and the electrode 24 have been formed. The polyimide layer 25 can be formed by coating a polyimide material and hardening the coated polyimide material.

The magnetic shield 30 is formed on the polyimide layer 25. The magnetic shield 30 may be made of a material having high magnetic permeability, such as an amorphous magnetic material, a Permalloy-based magnetic material, or an iron-based microcrystal material. It is to be noted that the magnetic shield 30 can be omitted as appropriate.

Furthermore, a silicon oxide film 31 is formed on the polyimide layer 25. The silicon oxide film 31 can be formed by sputtering or some other suitable method. A contact hole is formed in a predetermined region (corresponding to a region where the electrode 24 exists) in each of the polyimide layer 25 and the silicon oxide film 31, and an electrode pad 26 is formed in the contact hole. For example, photolithography and etching can be used to form the contact hole. The electrode pad 26 can be formed by forming a film of an electrode material, and thereafter executing the photolithography and the etching.

In the magnetic proportional current sensor having the above-described structure, as illustrated in Fig. 3, the magnetoresistive element receives the induced magnetic field A generated from the measured current I and outputs a voltage corresponding to change in resistance thereof.

The magnetic proportional current sensor of the present invention includes the magnetic shield 30 as illustrated in Fig. 3. The magnetic shield 30 can attenuate the induced magnetic field generated from the measured current I and applied to the magnetoresistive element. Accordingly, even when the induced magnetic field A is large, the current can be measured. In other words, the current measurement can be performed over a wider range. Moreover, the magnetic shield 30 can reduce the influence of an external magnetic field.

The magnetic proportional current sensor having the above-described structure employs the magnetism detection bridge circuit 13 including, as the magnetism detection element, the magnetoresistive element, particularly the GMR element or the TMR element. As a result, the magnetic proportional current sensor having high sensitivity can be realized. Furthermore, in the magnetic proportional current sensor described above, since the magnetic-field detection bridge circuit 13 is constituted by four magnetoresistive elements having the same structure, deviations in the zero-field resistance value ($R_0$) and the Temperature Coefficient Resistivity ($TCR_0$) among the elements can be eliminated. Therefore, variations of a midpoint potential can be reduced regardless of the environmental temperature, and the current measurement can be performed with high accuracy. Moreover, in the magnetic proportional current sensor having the above-described structure, since the magnetic shield 30 and the magnetic-field detection bridge circuit 13 are formed on the same substrate, the sensor size can be reduced. In addition, since the magnetic proportional current sensor described above does not include a magnetic core, it is possible to realize reduction in size and cost.

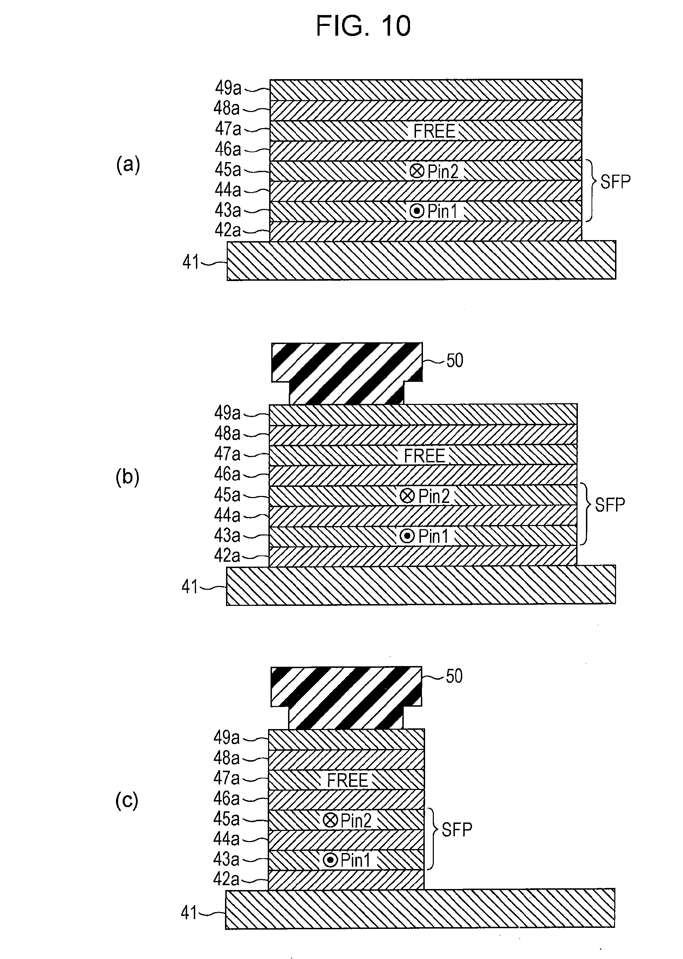

The film structure of the magnetoresistive element used in the present invention is, for example, as per illustrated in Fig. 10(a). Thus, as illustrated in Fig. 10(a), the magnetoresistive element has a multilayered structure formed on the substrate 41. It is to be noted that, for the sake of simplification of explanation, other layers, such as an underlying layer, formed on the substrate 41 than those constituting the magnetoresistive element are omitted in Fig. 10(a). The magnetoresistive element includes a seed layer 42a, a first ferromagnetic film 43a, an antiparallel coupling film 44a, a second ferromagnetic film 45a, a nonmagnetic intermediate layer 46a, soft magnetic free layers (free magnetic layers) 47a and 48a, and a protective layer 49a.

The seed layer 42a is made of, e.g., NiFeCr or Cr. The protective layer 49a is made of, e.g., Ta. In the above-described multilayered structure, an underlying layer made of a nonmagnetic material containing at least one element selected from Ta, Hf, Nb, Zr, Ti, Mo and W, for example, may be disposed between the substrate 41 and the seed layer 42a.

In the magnetoresistive element described here, the first ferromagnetic film 43a and the second ferromagnetic film 45a are antiferromagnetically coupled to each other through the antiparallel coupling film 44a, whereby a ferromagnetic pinned layer of self-pinned type (called an SFP layer: Synthetic Ferri Pinned layer) is constituted.

In the ferromagnetic pinned layer of that type, strong antiferromagnetic coupling can be developed between the first ferromagnetic film 43a and the second ferromagnetic film 45a by setting a thickness of the antiparallel coupling film 44a to be 0.3 nm to 0.45 nm or 0.75 nm to 0.95 nm.

Furthermore, a magnetization magnitude (Ms·t) of the first ferromagnetic film 43a and a magnetization magnitude (Ms·t) of the second ferromagnetic film 45a are substantially equal to each other. In other words, a difference in magnetization magnitude between the first ferromagnetic film 43a and the second ferromagnetic film 45a is substantially zero. Therefore, an effective anisotropic magnetic field in the SFP layer is large. As a result, stability in magnetization of the ferromagnetic pinned layer (Pin layer) can be sufficiently ensured without using an antiferromagnetic material. This is because, given that a thickness of the first ferromagnetic film is denoted by $t_1$, a thickness of the second ferromagnetic film is denoted by $t_2$, and a magnetization and an induced magnetic anisotropy constant per unit volume of both the ferromagnetic films are denoted by Ms and K, respectively, the effective anisotropic magnetic field in the SFP layer is expressed by the following formula (1). Thus, the magnetoresistive element used in the magnetic proportional current sensor of the present invention has the film structure including no antiferromagnetic layer.

$$\text{Formula (1)}$$

$$\text{eff } Hk = 2(K \cdot t_1 + K \cdot t_2)/(Ms \cdot t_1 - Ms \cdot t_2)$$

The Curie temperature (Tc) of the first ferromagnetic film 43a and the Curie temperature (Tc) of the second ferromagnetic film 45a are substantially equal to each other. Even in environment at high temperature, therefore, the difference in magnetization magnitude (Ms·t) between both the films 43a and 45a is substantially zero, and high magnetization stability can be maintained.

The first ferromagnetic film 43a is preferably made of a CoFe alloy containing 40 atom% to 80 atom% of Fe. The reason is that the CoFe alloy in such a composition range has a large coercive force and can stably maintain magnetization with respect to an external magnetic field. Also, the second ferromagnetic film 45a is preferably made of a CoFe alloy containing 0 atom% to 40 atom% of Fe. The reason is that the CoFe alloy in such a composition range has a small coercive force and makes the first ferromagnetic film 43a more apt to magnetize in an antiparallel direction (i.e., a direction differing by 180°) with respect to the direction in which the first ferromagnetic film 43a is preferentially magnetized. As a result, Hk expressed by the above formula (1) can be further increased. In addition, by limiting the second ferromagnetic film 45a to fall within the above-mentioned composition range, a resistance change rate of the magnetoresistive element can be increased.

Preferably, during formation of the first ferromagnetic film 43a and the second ferromagnetic film 45a, a magnetic field is applied to each film in the widthwise direction of the stripe in the meander shape such that induced magnetic anisotropy is given to the first ferromagnetic film 43a and the second ferromagnetic film 45a after being formed. As a result, the films 43a and 45a are magnetized in the widthwise direction of the stripe in antiparallel relation. Moreover, because the magnetization direction of each of the first ferromagnetic film 43a and the second ferromagnetic film 45a is determined depending on the direction in which a magnetic field is applied during the formation of the first ferromagnetic film 43a, a plurality of magnetoresistive elements including ferromagnetic pinned layers, which have different magnetization directions, can be formed on the same substrate by changing the direction in which a magnetic field is applied during the formation of the first ferromagnetic film 43a.

The antiparallel coupling film 44a in the ferromagnetic pinned layer is made of, e.g., Ru. The soft magnetic free layers (free magnetic layers) 47a and 48a are each made of a magnetic material, e.g., a CoFe alloy, a NiFe alloy, or a CoFeNi alloy. The nonmagnetic intermediate layer 46a is made of, e.g., Cu. Furthermore, during formation of the soft magnetic free layers 47a and 48a, a magnetic field is preferably applied to each layer in the lengthwise direction of the stripe in the meander shape such that induced magnetic anisotropy is given to the soft magnetic free layers 47a and 48a after being formed. As a result, in the magnetoresistive element, resistance is linearly changed with respect to an external magnetic field in the widthwise direction of the stripe (i.e., to a magnetic field induced by the measured current), and hysteresis can be reduced. In the magnetoresistive element described above, a spin valve structure is constituted by the ferromagnetic pinned layer, the nonmagnetic intermediate layer, and the soft magnetic free layers.

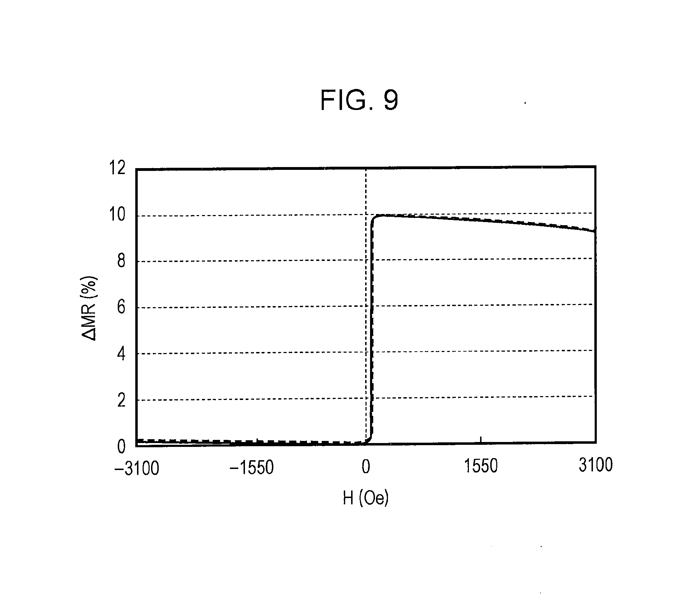

The film structure of the magnetoresistive element used in the magnetic proportional current sensor of the present invention is, for example, made up of NiFeCr (the seed layer: 5 nm) / $Fe_{70}Co_{30}$ (the first ferromagnetic film: 1.65 nm) / Ru (the antiparallel coupling film: 0.4 nm) / $Co_{90}Fe_{10}$ (the second ferromagnetic film: 2 nm) / Cu (the nonmagnetic intermediate layer: 2.2 nm) / $Co_{90}Fe_{10}$ (the soft magnetic free layer: 1 nm) / NiFe (the soft magnetic free layer: 7 nm) / Ta (the protective layer: 5 nm). As a result of examining an R-H waveform for the magnetoresistive element having the above-mentioned film structure, the R-H waveform was obtained as illustrated in Fig. 9. As seen from Fig. 9, the obtained R-H waveform had a similar characteristic to that of an R-H waveform of a magnetoresistive element of the type employing an antiferromagnetic film to pin the magnetization of a pinned magnetic layer. Note that the R-H waveform illustrated in Fig. 9 was determined under conditions set in ordinary measurement.

In the magnetic proportional current sensor of the present invention, as illustrated in Fig. 4, among the four magnetoresistive elements 122a to 122c and 123, the magnetization directions of the ferromagnetic pinned layers (i.e., the magnetization directions of the second ferromagnetic films: Pin2) in the three magnetoresistive elements 122a to 122c are the same, and the magnetization direction of the ferromagnetic pinned layer (i.e., the magnetization direction of the second ferromagnetic film: Pin2) in the remaining one magnetoresistive element 123 is different by 180° from the magnetization directions of the ferromagnetic pinned layers in the three magnetoresistive elements 122a to 122c.

In the magnetic proportional current sensor including the four magnetoresistive elements arranged as described above, the current to be measured is measured by detecting a voltage difference between two outputs (OUT1 and OUT2) of the magnetism detection bridge circuit 13. Here, zero-field resistance values of the four magnetoresistive elements are substantially the same ($R_0$). Moreover, resistance changes of the four magnetoresistive elements are substantially proportional to the intensity of the magnetic field, and resistance change rates thereof are also substantially the same.

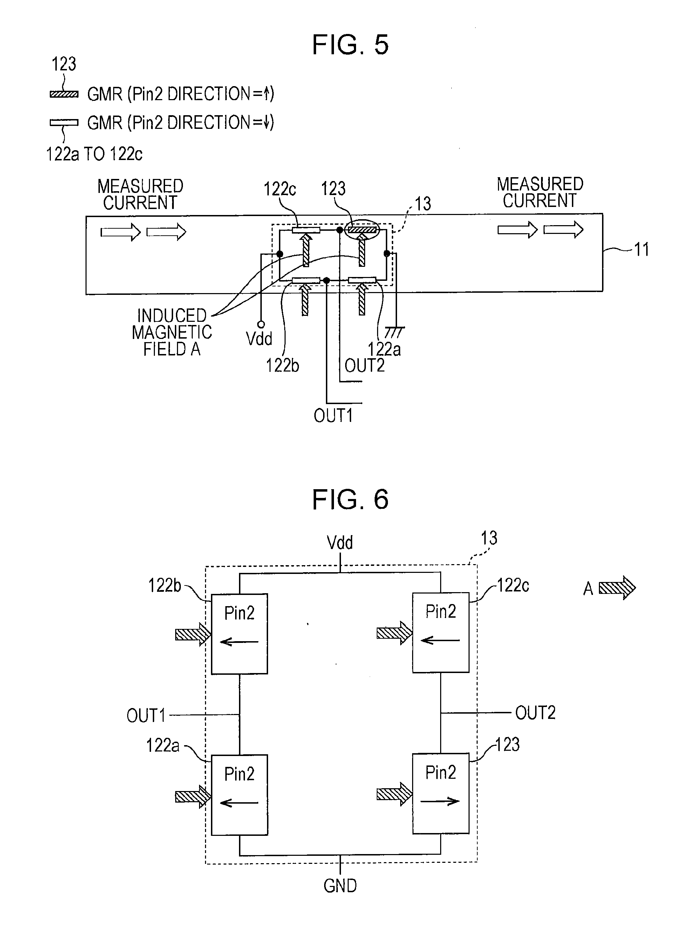

When, as illustrated in Fig. 5, the current to be measured flows from the left side as viewed on the drawing sheet of Fig. 5, the induced magnetic field A is applied to the four magnetoresistive elements 122a to 122c and 123 in the same direction, as illustrated in Fig. 6.

Because the magnetization directions of the ferromagnetic pinned layers in the two magnetoresistive elements 122a and 122b (on the OUT1 side) are the same, a resistance value of the magnetoresistive element 122a and a resistance value of the magnetoresistive element 122b are always the same regardless of the intensity of the induced magnetic field A. Accordingly, the output OUT1 is always constant (Vdd/2). Hence the magnetoresistive elements 122a and 122b take the same role as that of a fixed resistance element.

On the other hand, because the magnetization directions of the ferromagnetic pinned layers in the two magnetoresistive elements 122c and 123 (on the OUT2 side) are antiparallel to each other, resistances of the magnetoresistive elements 122c and 123 are changed in different directions depending on the intensity of the induced magnetic field A. Assuming that resistance change of the magnetoresistive element 122c caused by the induced magnetic field is $-\Delta R$, the resistance value of the magnetoresistive element 122c is $R_0 - \Delta R$ and the resistance value of the magnetoresistive element 123 is $R_0 + \Delta R$. In other words, a resultant resistance value of the magnetoresistive elements 122c and 123 is $2R_0$ regardless of the induced magnetic field A. Accordingly, the output OUT2 is given by:

$$V_{OUT2} \; = \; Vdd \cdot (R_0 \; + \; \Delta R) / 2R_0 \; = \; Vdd/2 \; + \; Vdd \cdot \Delta R / 2R_0$$

Thus, the resistance change $\Delta R$ and the output OUT2 are substantially in linear relation. Because the output OUT1 is always Vdd/2, the voltage difference between OUT1 and OUT2 is expressed by $Vdd \cdot \Delta R / 2R_0$ (or $-Vdd \cdot \Delta R / 2R_0$) and is substantially proportional to the resistance change $\Delta R$. Because $\Delta R$ is substantially proportional to the intensity of the magnetic field, the voltage difference substantially in proportional relation to the induced magnetic field is obtained.

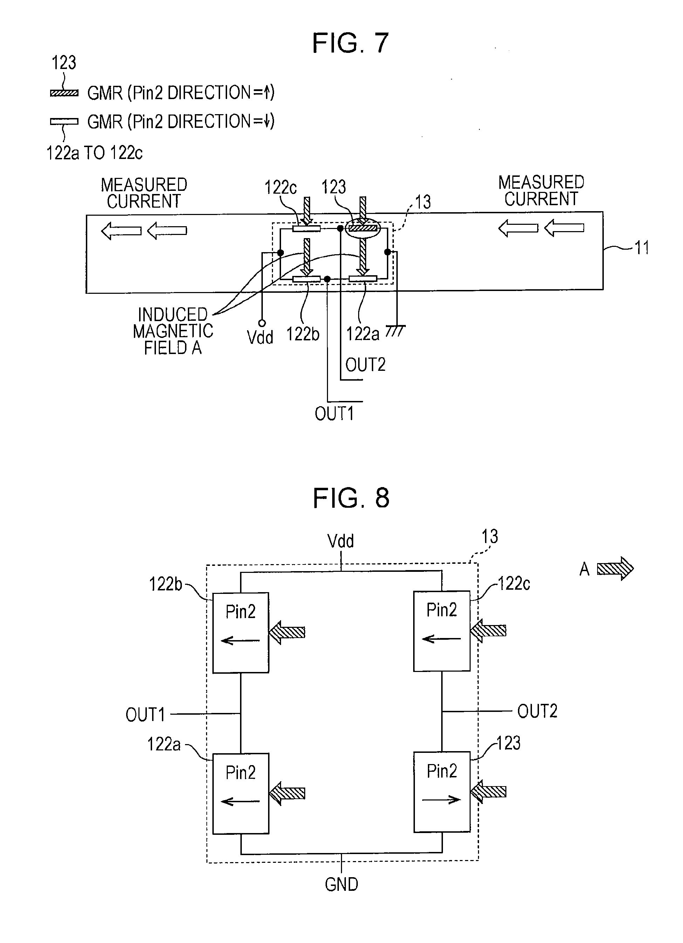

Moreover, when, as illustrated in Fig. 7, the current to be measured flows from the right side as viewed on the drawing sheet of Fig. 7, the induced magnetic field A is applied to the two magnetoresistive elements 122a and 122b (on the OUT1 side) and the two magnetoresistive elements 122c and 123 (on the OUT2 side) as illustrated in Fig. 8. The operation in such a case is similar to that in the case of Figs. 5 and 6.

In the magnetic proportional current sensor of the present invention, as described above, the magnetism detection bridge circuit 13 is constituted by the four magnetoresistive elements having the same film structure, and the magnetization direction of the first ferromagnetic film (or the second ferromagnetic film) in one magnetoresistive element is set antiparallel to the magnetization direction of the first ferromagnetic film (or the second ferromagnetic film) in each of the other three magnetoresistive elements. Therefore, the zero-field resistance values ($R_0$) and the Temperature Coefficient Resistivities ($TCR_0$) of the four magnetoresistive elements can be held in match with one another, and a current sensor can be realized in which a midpoint potential is not varied depending on temperature change and high accuracy is ensured.

A magnetic proportional current sensor employing four magnetoresistive elements as in the above-described magnetic proportional current sensor can also be manufactured using magnetoresistive elements of the type employing an antiferromagnetic film to pin the magnetization of each pinned magnetic layer. In such a case, in order to make an exchange coupling direction of the pinned magnetic layer (Pin layer) in one among the four magnetoresistive elements antiparallel to an exchange coupling direction of the pinned magnetic layer in each of the other three magnetoresistive elements, it is required to execute laser local annealing or to install a magnetic field applying coil adjacent to the relevant magnetoresistive element. Such a scheme can be applied to the case of manufacturing a sensor or a device in which the magnetoresistive elements are present near the uppermost surface of a chip, but it is not suitable for manufacturing a device in which a thick organic insulating film, a thick magnetic shield film, etc. are formed over the magnetoresistive elements, as in the magnetic proportional current sensor of the present invention. For that reason, the magnetoresistive elements including no antiferromagnetic films, as described above, are particularly useful in the magnetic proportional current sensor according to the present invention.

In the magnetic proportional current sensor according to the present invention, the magnetoresistive elements and other components, such as wirings, are insulated by the organic insulating film, e.g., the polyimide film. The organic insulating film is generally formed by coating an organic material by, e.g., spin coating, and thereafter executing heat treatment at 200°C or higher. Because the organic insulating film is formed in a step after forming the magnetism detection bridge circuit, the magnetoresistive elements are also heated together. In a step of manufacturing the magnetoresistive element of the type employing the antiferromagnetic film to pin the magnetization of the pinned magnetic layer, the heat treatment needs to be executed while applying a magnetic field such that the characteristics of the pinned magnetic layer will not degrade due to thermal hysteresis caused in the step of forming the organic insulating film. In the magnetic proportional current sensor according to the present invention, because of not using the antiferromagnetic film, the characteristics of the pinned magnetic layer can be maintained with no need of applying a magnetic field during the heat treatment. Accordingly, it is possible to suppress degradation of hysteresis of the soft magnetic free layer in which an easy magnetization axis is perpendicular to the direction of a magnetic field applied during the heat treatment.

Furthermore, when the magnetoresistive element of the type employing the antiferromagnetic film to pin the magnetization of the pinned magnetic layer is used, the characteristics of the pinned magnetic layer become more unstable at higher temperature for the reason that the blocking temperature (i.e., the temperature at which the exchange coupling magnetic field disappears) of an antiferromagnetic material is about 300°C to 400°C, and that the exchange coupling magnetic field gradually reduces as temperature approaches the blocking temperature. In the magnetic proportional current sensor according to the present invention, because of not using the antiferromagnetic film, the characteristics of the pinned magnetic layer mainly depend on the Curie temperature of a ferromagnetic material constituting the pinned magnetic layer. In general, the Curie temperatures of ferromagnetic materials, such as CoFe, are much higher than the blocking temperatures of antiferromagnetic materials. Accordingly, high magnetization stability can be maintained by setting the Curie temperatures of ferromagnetic materials of the first ferromagnetic film and the second ferromagnetic film to be matched with each other, and by keeping the difference in magnetization magnitude (Ms·t) therebetween zero even in a high temperature region.

Moreover, when the magnetoresistive element of the type employing the antiferromagnetic film to pin the magnetization of the pinned magnetic layer is used, a difference needs to be intentionally given between the magnetization magnitude (Ms·t) of the first ferromagnetic film and the magnetization magnitude (Ms·t) of the second ferromagnetic film in order to generate an exchange coupling magnetic field in the direction in which a magnetic field is applied during the annealing. The reason is as follows. If the difference in magnetization magnitude is zero, a magnetic field at which the first ferromagnetic film and the second ferromagnetic film are both saturated exceeds a magnetic field (up to 15 kOe ($\times$ $10^3/4\pi$ A/m)) that can be applied during the annealing. As a result, magnetization dispersion in the first ferromagnetic film and the second ferromagnetic film after the annealing increases, thus causing degradation of $\Delta R/R$. Moreover, for increasing $\Delta R/R$, the thickness (or the magnetization magnitude) of the second ferromagnetic film is often increased from that of the first ferromagnetic film. In general, when the magnetization magnitude of the second ferromagnetic film is larger than that of the first ferromagnetic film, a return magnetic field applied to the soft magnetic free layer from the second ferromagnetic film at sidewalls of the element increases, and an influence upon output asymmetry increases. Because temperature dependence of the return magnetic field is large, temperature dependence of the asymmetry is also large. In the magnetic proportional current sensor according to the present invention, such a problem can be overcome because the difference in magnetization magnitude between the first ferromagnetic film and the second ferromagnetic film of the magnetoresistive element is zero.

In addition, since the magnetoresistive element in the magnetic proportional current sensor according to the present invention contains no antiferromagnetic materials, the material cost and the manufacturing cost can be held down.

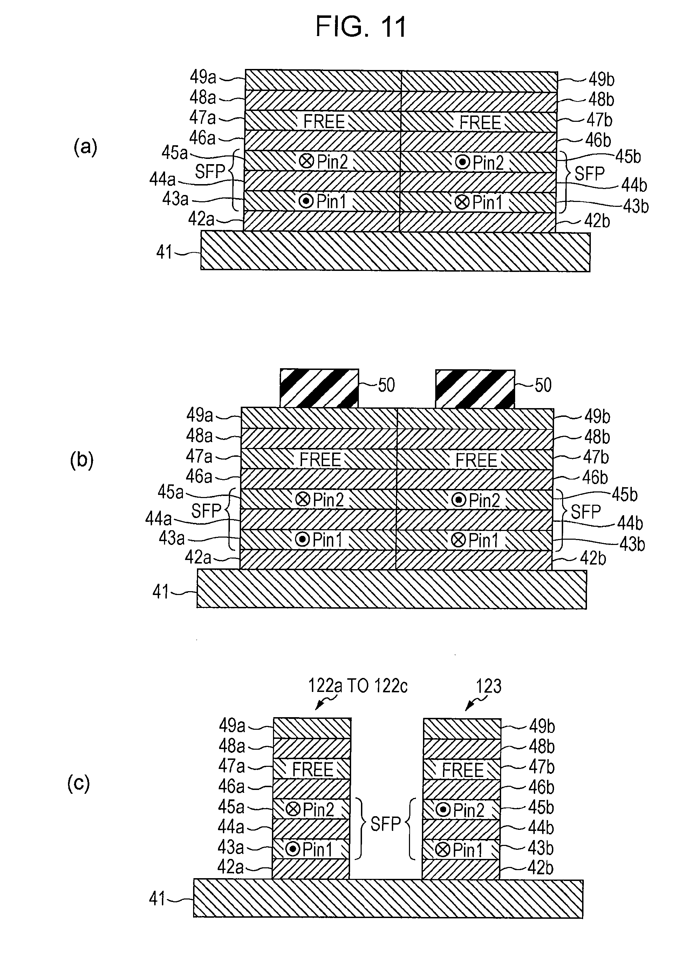

Figs. 10(a) to 10(c) and Figs. 11(a) to 11(c) are explanatory views to explain a method for manufacturing the magnetoresistive element in the magnetic proportional current sensor according to the embodiment of the present invention. First, as illustrated in Fig. 10(a), the seed layer 42a, the first ferromagnetic film 43a, the antiparallel coupling film 44a, the second ferromagnetic film 45a, the nonmagnetic intermediate layer 46a, the soft magnetic free layers (free magnetic layers) 47a and 48a, and the protective layer 49a are successively formed on the substrate 41. During the steps of forming the first ferromagnetic film 43a and the second ferromagnetic film 45a, a magnetic field is applied in the widthwise direction of the stripe in the meander shape. In Fig. 10, for each of the first ferromagnetic film 43a and the second ferromagnetic film 45a, the magnetic field is applied in a direction toward the front side from the rear side of the drawing sheet. After the film formation, the first ferromagnetic film 43a is preferentially magnetized in the direction of application of the magnetic field, and the second ferromagnetic film 45a is magnetized in an antiparallel direction (i.e., a direction differing by 180°) with respect to the magnetization direction of the first ferromagnetic film 43a. Furthermore, during the steps of forming the soft magnetic free layers (free magnetic layers) 47a and 48a, a magnetic field is applied in the lengthwise direction of the stripe in the meander shape.

Next, as illustrated in Fig. 10(b), a resist layer 50 is formed on the protective layer 49a, and the resist layer 50 is subjected to photolithography and etching such that the resist layer 50 partly remains on a region in the side including the magnetoresistive elements 122a to 122c. Next, as illustrated in Fig. 10(c), an exposed portion of the multilayered films is removed by, e.g., ion milling to expose a region of the substrate 41 where the magnetoresistive element 123 is to be disposed.

Next, as illustrated in Fig. 11(a), a seed layer 42b, a first ferromagnetic film 43b, an antiparallel coupling film 44b, a second ferromagnetic film 45b, a nonmagnetic intermediate layer 46b, soft magnetic free layers (free magnetic layers) 47b and 48b, and a protective layer 49b are successively formed on the exposed region of the substrate 41. During the steps of forming the first ferromagnetic film 43b and the second ferromagnetic film 45b, a magnetic field is applied in the widthwise direction of the stripe in the meander shape. In Fig. 11, for each of the first ferromagnetic film 43b and the second ferromagnetic film 45a, the magnetic field is applied in a direction toward the rear side from the front side of the drawing sheet. Based on the same principle as that described above, the first ferromagnetic film 43a and the second ferromagnetic film 45a are magnetized in directions antiparallel to each other (i.e., directions differing by 180°). Furthermore, during the steps of forming the soft magnetic free layers (free magnetic layers) 47b and 48b, a magnetic field is applied in the lengthwise direction of the stripe in the meander shape.

Next, as illustrated in Fig. 11(b), resist layers 50 are formed on the protective layer 49a and 49b, and both the resist layers 50 are subjected to photolithography and etching such that the resist layers 50 remain on regions where the magnetoresistive elements 122a to 122c and 123 are to be formed. Next, as illustrated in Fig. 11(c), exposed portions of the multilayered films are removed by, e.g., ion milling, whereby the magnetoresistive elements 122a to 122c and 123 are formed.

In the magnetic proportional current sensor of the present invention, as described above, since the magnetism detection bridge circuit is constituted by the four magnetoresistive elements having the same film structure, deviations in the zero-field resistance value ($R_0$) and the Temperature Coefficient Resistivity ($TCR_0$) among the elements can be eliminated. Therefore, variations of a midpoint potential can be reduced regardless of the environmental temperature, and the current measurement can be performed with high accuracy.

The present invention is not limited to the above-described embodiment, and it can be implemented in various modified forms. For example, the materials, the connecting relations among the elements, the thicknesses and sizes of the elements, the manufacturing method, etc. can be variously modified in practice. In addition, the present invention can be implemented in forms changed as appropriate without departing from the scope of the present invention.

Industrial Applicability

The present invention is applicable to a current sensor for detecting the magnitude of a current to drive a motor in an electric car.

This application is based on Japanese Patent Application No. 2010-289629 filed December 27, 2010, which is hereby incorporated by reference herein in its entirety.

**Claims**

1.  A magnetic proportional current sensor comprising a magnetic-field detection bridge circuit constituted by four magnetoresistive elements having resistance values changed with application of an induced magnetic field from a current to be measured, the magnetic-field detection bridge circuit having two outputs generating a voltage difference substantially proportional to the induced magnetic field, and a magnetic shield for attenuating the induced magnetic field, the magnetic proportional current sensor calculating a current value of the measured current by employing the voltage difference generated in the magnetic-field detection bridge circuit,
    wherein each of the four magnetoresistive elements includes a ferromagnetic pinned layer of self-pinned type made up of a first ferromagnetic film and a second ferromagnetic film antiferromagnetically coupled to each other with an antiparallel coupling film interposed therebetween, a nonmagnetic intermediate layer, and a soft magnetic free layer, the first ferromagnetic film and the second ferromagnetic film having substantially equal Curie temperatures and having magnetization magnitudes with a substantially zero difference therebetween, the ferromagnetic pinned layers in three of the four magnetoresistive elements have a same magnetization direction, and the ferromagnetic pinned layer in the remaining one magnetoresistive element has a magnetization direction differing by 180° from the magnetization direction of the ferromagnetic pinned layers in the three magnetoresistive elements.

2.  The magnetic proportional current sensor according to Claim 1, wherein the magnetic shield and the magnetic-field detection bridge circuit are formed on a same substrate.

3.  The magnetic proportional current sensor according to Claim 1 or 2, wherein the magnetic shield is arranged on a side closer to the measured current than the magnetic-field detection bridge circuit.

4.  The magnetic proportional current sensor according to any one of Claims 1 to 3, wherein each of the four magnetoresistive elements has a zigzag folded shape in which a plurality of band-like elongate patterns are arranged with lengthwise directions of the patterns being parallel to each other, and the induced magnetic field is applied in a direction perpendicular to the lengthwise direction.

5.  The magnetic proportional current sensor according to any one of Claims 1 to 4, wherein the first ferromagnetic film is made of a CoFe alloy containing 40 atom% to 80 atom% of Fe, and the second ferromagnetic film is made of a CoFe alloy containing 0 atom% to 40 atom% of Fe.

6.  The magnetic proportional current sensor according to any one of Claims 1 to 5, wherein the magnetic shield is made of a material having high magnetic permeability, selected from a group consisted of an amorphous magnetic material, a Permalloy-based magnetic material, and an iron-based microcrystal material.

# FIG. 1

INDUCED MAGNETIC
FIELD A

Vdd

13

11

122b

122c

Out1

Out2

123

MEASURED
CURRENT I

122a

# FIG. 2

123

GMR (Pin2 DIRECTION=↑)

GMR (Pin2 DIRECTION=↓)

122a TO 122c

ENLARGE

Pin
DIRECTION

122c    123

13

11

Vdd

122b    122a

Out2

Out1

FIG. 3

MEASURED CURRENT I

INDUCED
MAGNETIC FIELD A

30

31

A

A

26

25

24
23
22
21

122a TO 122c, 123

FIG. 4

Vdd

13

Pin2

Pin2

122b

122c

OUT1

OUT2

Pin2

Pin2

122a

123

GND

# FIG. 5

123

▨▨ GMR (Pin2 DIRECTION=↑)

▭ GMR (Pin2 DIRECTION=↓)

122a TO 122c

# FIG. 6

# FIG. 7

123
⬛▨ GMR (Pin2 DIRECTION=↑)

▭ GMR (Pin2 DIRECTION=↓)

122a TO 122c

MEASURED
CURRENT

122c    123        13

⬅  ⬅

INDUCED
MAGNETIC
FIELD A

Vdd    122b    122a 777

OUT2

OUT1

MEASURED
CURRENT

⬅  ⬅

11

# FIG. 8

Vdd        13

122b        122c

Pin2    Pin2    A ⬛▨

OUT1        OUT2

122a        123

Pin2    Pin2

GND

# FIG. 9

# FIG. 10

(a)

49a
48a
47a — FREE
46a
45a — ⊗Pin2
44a
43a — ⊙Pin1
42a
41

} SFP

(b)

50

49a
48a
47a — FREE
46a
45a — ⊗Pin2
44a
43a — ⊙Pin1
42a
41

} SFP

(c)

50

49a
48a
47a — FREE
46a
45a — ⊗Pin2
44a
43a — ⊙Pin1
42a
41

} SFP

# FIG. 11

(a)

49a — 49b
48a — 48b
47a — FREE — FREE — 47b
46a — 46b
45a — ⊗Pin2 — ⊙Pin2 — 45b
SFP
44a — SFP — 44b
43a — ⊙Pin1 — ⊗Pin1 — 43b
42a — 42b

41

(b)

— 50 — 50

49a — 49b
48a — 48b
47a — FREE — FREE — 47b
46a — 46b
45a — ⊗Pin2 — ⊙Pin2 — 45b
SFP
44a — SFP — 44b
43a — ⊙Pin1 — ⊗Pin1 — 43b
42a — 42b

41

(c)

122a TO 122c          123

49a — 49b
48a — 48b
47a — FREE — FREE — 47b
46a — 46b
45a — ⊗Pin2 — ⊙Pin2 — 45b
44a — SFP — 44b
43a — ⊙Pin1 — ⊗Pin1 — 43b
42a — 42b

41

## INTERNATIONAL SEARCH REPORT

| International application No. |
| --- |
| PCT/JP2011/077245 |

A.  CLASSIFICATION OF SUBJECT MATTER
*G01R33/09*(2006.01)i, *G01R15/20*(2006.01)i

According to International Patent Classification (IPC) or to both national classification and IPC

B.  FIELDS SEARCHED

Minimum documentation searched (classification system followed by classification symbols)
G01R15/14-26, G01R33/09, G01R19/00-32, G01R21/08, H01F38/20-40

Documentation searched other than minimum documentation to the extent that such documents are included in the fields searched
Jitsuyo Shinan Koho          1922-1996   Jitsuyo Shinan Toroku Koho   1996-2011
Kokai Jitsuyo Shinan Koho    1971-2011   Toroku Jitsuyo Shinan Koho   1994-2011

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| A | WO 2010/143718 A1  (Alps Green Devices Co., Ltd.), 16 December 2010 (16.12.2010), entire text; all drawings (Family: none) | 1-6 |
| A | JP 2009-180604 A  (Hitachi Metals, Ltd.), 13 August 2009 (13.08.2009), entire text; all drawings & US 2010/0327857 A1    & EP 2256463 A1 & WO 2009/096093 A1      & CN 101932912 A | 1-6 |
| A | JP 2004-132790 A  (Fuji Electric Holdings Co., Ltd.), 30 April 2004 (30.04.2004), entire text; all drawings (Family: none) | 1-6 |

| ☒  Further documents are listed in the continuation of Box C. | ☐   See patent family annex. |
| --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search 20 December, 2011 (20.12.11) | Date of mailing of the international search report 24 January, 2012 (24.01.12) |
| --- | --- |
| Name and mailing address of the ISA/ Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/077245

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2010-258981 A  (Alps Green Devices Co., Ltd.),<br>11 November 2010 (11.11.2010),<br>entire text; all drawings<br>(Family: none) | 1-6 |
| A | JP 2003-060256 A  (Alps Electric Co., Ltd.),<br>28 February 2003 (28.02.2003),<br>entire text; all drawings<br>& US 2003/0030522 A1    & EP 1292029 A2 | 1-6 |
| A | JP 2007-263654 A  (Hitachi Metals, Ltd.),<br>11 October 2007 (11.10.2007),<br>entire text; all drawings<br>(Family: none) | 1-6 |

Form PCT/ISA/210 (continuation of second sheet) (July 2009)

**EP 2 660 617 A1**

**REFERENCES CITED IN THE DESCRIPTION**

**Patent documents cited in the description**

- JP 2007248054 A

- JP 2010289629 A